(19) Europäisches Patentamt
European Patent Office
Office européen des brevets

(11) **EP 4 309 477 B1**

(12) **EUROPÄISCHE PATENTSCHRIFT**

(45) Veröffentlichungstag und Bekanntmachung des Hinweises auf die Patenterteilung:
**04.03.2026 Patentblatt 2026/10**

(21) Anmeldenummer: **21731706.4**

(22) Anmeldetag: **31.05.2021**

(51) Internationale Patentklassifikation (IPC):
***H05K 13/08*** (2006.01)

(52) Gemeinsame Patentklassifikation (CPC):
**H05K 13/085**

(86) Internationale Anmeldenummer:
**PCT/EP2021/064574**

(87) Internationale Veröffentlichungsnummer:
**WO 2022/253408 (08.12.2022 Gazette 2022/49)**

(54) **VERFAHREN UND STEUEREINRICHTUNG ZUR BESTIMMUNG MINDESTENS EINER FESTRÜSTUNG FÜR EINE BESTÜCKUNGSLINIE**

METHOD AND CONTROL DEVICE FOR IDENTIFYING AT LEAST ONE FIXED SETUP FOR AN ASSEMBLY LINE

PROCÉDÉ ET DISPOSITIF DE COMMANDE POUR IDENTIFIER AU MOINS UNE INSTALLATION FIXE POUR UNE LIGNE DE MONTAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**24.01.2024 Patentblatt 2024/04**

(73) Patentinhaber: **Siemens Aktiengesellschaft 80333 München (DE)**

(72) Erfinder:
• PFAFFINGER, Alexander
  **81739 München (DE)**
• ROYER, Christian
  **85521 Ottobrunn (DE)**

(74) Vertreter: **Siemens Patent Attorneys Postfach 22 16 34 80506 München (DE)**

(56) Entgegenhaltungen:
**WO-A1-2008/071280     US-A1- 2010 325 860**

**Beschreibung**

Die Erfindung betrifft ein Verfahren und eine Steuereinrichtung zur Bestimmung mindestens einer Rüstung für eine Bestückungslinie, welche mit einem Leiterplattendoppeltransportsystem eingerichtet ist, sowie ein zugehöriges Computerprogrammprodukt.

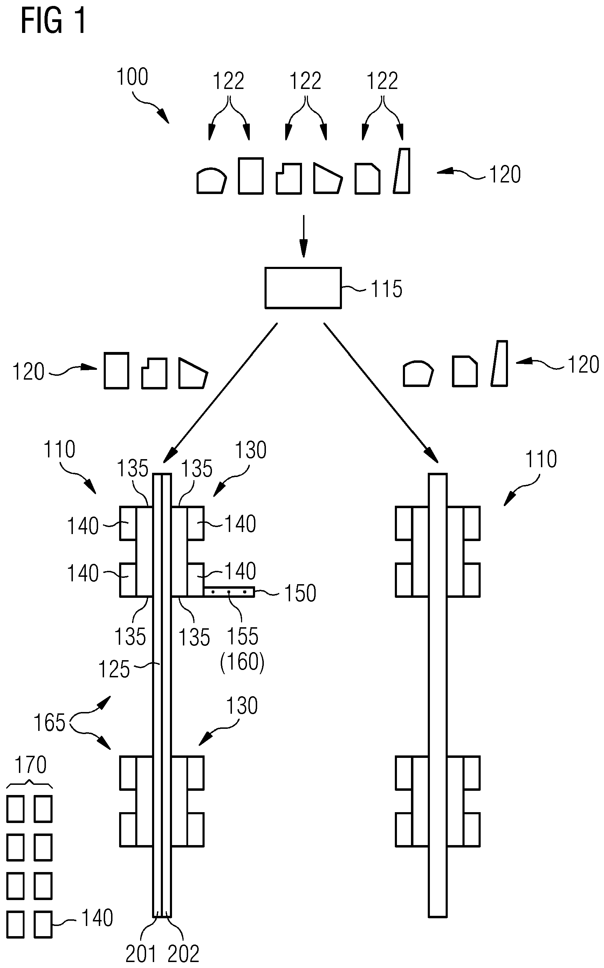

Eine Bestückungslinie ist zur Bestückung einer Leiterplatte (LP) mit einer Anzahl Bauelemente eingerichtet. Eine solche Bestückungslinie ist beispielsweise in Figur 1 gezeigt, welche nachstehend zum Ausführungsbeispiel noch näher erläutert wird. Bei SMT (Surface mounted technology) werden die Bauelemente auf Leiterplatten bestückt und gelötet. Ein an der Bestückungslinie stehender Bestückungsautomat umfasst einen oder mehrere Bestückungsköpfe, die jeweils dazu eingerichtet sind, Bauelemente aufzunehmen und an einer vorbestimmten Position auf der Leiterplatt zu positionieren, die sich auf einem Transportsystem befindet. Es gibt mehrere Kopftypen. Nach dem Prinzip "Pick&Place" werden z.B. Zwillingsköpfe (TwinHead) eingesetzt, die wenige große Bauelemente aufnehmen können. Nach dem Prinzip "Collect&Place" werden z.B. der Revolverköpfe eingesetzt, der viele kleine Bauelemente aufnehmen können.

In der Fertigung werden für einen Planungshorizont (ca. 1-5 Tage) die zu fertigenden Leiterplattentypen in Rüstfamilien ("Cluster") aufgeteilt. Eine Rüstfamilie ist dabei eine Menge von Leiterplattentypen, die mit einer vorbestimmten Anzahl von Bauelementen auf der Bestückungslinie produzierbar/fertigbar ist. Die Menge der hierfür benötigten Bauelementtypen wird Rüstung genannt und ist üblicherweise in einem Satz von Wechseltischen aufgenommen. Ein Wechseltisch wird üblicherweise in der Vorrüstung zur Produktion mit den passenden Bauelementen aufgerüstet und nachher wieder abgerüstet.

Eine Bestückungslinie kann mit einem Leiterplattendoppeltransportsystem eingerichtet ist. Der Leiterplattendoppeltransport kann eine erhebliche Steigerung des Durchsatzes bewirken. Er ermöglicht den gleichzeitigen (synchronen) oder abwechselnden bzw. zeitlich versetzten (asynchronen) Transport zweier Leiterplatten durch einen an der Bestückungslinie angebrachten Bestückautomaten. Bei der asynchronen Transportart wird während des Bestückens einer Leiterplatte eine zweite gleichen Leiterplattentyps zeitneutral in den Bestückungsautomaten eingefahren. Der durch Leiterplattentransport verursachte Nebenzeitanteil wird somit komplett eliminiert. Der zu erwartende Bestückungsleistungsgewinn liegt je nach Bauelementeinhalt der Leiterplatte zwischen 10 bis 30 Prozent.

Wenn auf dieser Bestückungslinie doppelseitig bestückbare Leiterplatten eines Leiterplattentyps transportiert werden, dann kann auf der ersten Transportspur die erste Seite (Oberseite) der Leiterplatte mit Bauelementen bestückt werden, und auf der zweiten Transportspur die zweite Seite (Unterseite) der Leiterplatte mit Bauelementen bestückt werden.

Gewöhnlich werden zunächst alle Leiterplatten eines Loses (Leiterplattentyp mit zu fertigender Stückzahl; Losgröße ist die Stückzahl der zu fertigenden Leiterplatten eines Leiterplattentyps) auf der einen Seite (z.B. der Oberseite) mit Bauelementen bestückt. Anschließend werden dann alle Leiterplatten des Loses auf der anderen Seite (z.B. der Unterseite) mit Bauelementen bestückt. Dieser Bestückungsmodus wird als asynchron bezeichnet. Gewöhnlich erfolgt dies mit einer Bauelement-Rüstung der Bestückungslinie.

Besitzt die Bestückungslinie einen synchronen Doppeltransport, so ist es möglich, auf der einen Transportspur die Oberseite einer Leiterplatte des Loses und auf der anderen Transportspur gleichzeitig die Unterseite der Leiterplatte des Loses zu bestücken, wodurch der Gesamtbestückinhalt an der Bearbeitungseinheit erhöht wird. Dieser Bestückungsmodus wird als synchron bezeichnet.

Ein Synchron-Betrieb kann die Produktionszeiten deutlich reduzieren. Dies basiert auf den folgenden beiden Effekten:

(1) Bei einer Bestückungslinie gibt es eine sogenannte externe Taktzeit (z.B. durch Drucker oder Brennofen). In einem Fertigungswerk liegt diese typischerweise bei 16s. Liegt die Taktzeit einer Leiterplattenseite im Asynchron-Betrieb unter den 16s, so ergibt sich eine unproduktive "Wartezeit" der Bestückungslinie. Diese lässt sich im Synchron-Modus reduzieren und damit auch die Gesamtproduktionszeit senken.
Vereinfachtes Beispiel: 1000 Stück. 16s externe Linien-Taktzeit

- Oberseite 10s Taktzeit, Unterseite 6s Taktzeit Produktionszeit im Asynchron-Betrieb = 1000 * (16 s+16s) = 32 000s

- Taktzeit Ober- und- Unterseite im Synchronbetrieb:

  16s Taktzeit
  Produktionszeit im Synchron-Betrieb = 1000 * 16s = 16 000s

(2) Ist der Bestückungsinhalt einer Seite mehr Revolverkopf-lastig (viele kleine Bauelemente) und der Bestückungsinhalt der anderen Seite mehr TwinHead-lastig (wenige große Bauelemente), so sind jeweils nur die Bestückköpfe eines Kopftyps der Bestückungslinie ausgelastet, während die anderen Köpfe unproduktiv warten. Im Synchron-Modus ergibt sich dann eine gleichmäßigere und höhere Auslastung aller Bestückungsköpfe der Bestückungslinie und damit eine niedrigere Gesamtproduktionszeit

US 2010/0325860 A1 offenbart ein Verfahren, aufweisend: Erfassen von Montageinformationen, einschließlich Informationen über die von einem Bestücker durchzuführenden Bauteilmontagevorgänge; Beurteilen anhand der beim Erfassen erhaltenen Montageinformationen, welcher Produktionsmodus - synchron oder asynchron - für die geplanten Bauteilmontagevorgänge geeignet ist; oder welcher Produktionsmodus - alternierend oder unabhängig - für die geplanten Bauteilmontagevorgänge geeignet ist; und Auswählen des durch das Ergebnis der Beurteilung ermittelten Produktionsmodus als den vom Bestücker auszuführenden Produktionsmodus.

Bei der Bildung der eingangs genannten Rüstfamilien für Synchron-Bestückungslinien sollten am besten die Leiterplattentypen gewählt werden, so dass der Produktionszeitgewinn gegenüber dem Betrieb der Leiterplattenbestückung im Asynchron-Modus möglichst hoch ist.

Die Aufgabe der Erfindung besteht darin, ein gegenüber des eingangs genannten Standes der Technik verbessertes Verfahren sowie eine verbesserte Steuereinrichtung anzugeben.

Diese Aufgabe wird durch die unabhängigen Ansprüche gelöst. Vorteilhafte Weiterbildungen sind Gegenstand der abhängigen Ansprüche.

Die Erfindung beansprucht ein Verfahren zur Bestimmung mindestens einer Festrüstung für eine Bestückungslinie, welche mit einem Leiterplattendoppeltransportsystem eingerichtet ist, dessen erste Transportspur doppelseitig bestückbare Leiterplatten eines Leiterplattentyps transportiert, deren erste Seite bestückt werden, und dessen zweite Transportspur doppelseitig bestückbare Leiterplatten des Leiterplattentyps (vor allem des gleichen Leiterplattentyps) transportiert, deren zweite Seite bestückt werden, wobei jede Festrüstung eine Anzahl an Bauelementtypen umfasst, die zur Bestückung der Leiterplatten einer dieser Festrüstung zugeordneten Festrüstungs-Rüstfamilie von Leiterplattentypen ausreicht, wobei die mindestens eine Festrüstung während des Planungshorizonts unverändert bleibt und mehrfach an der Bestückungslinie eingesetzt werden kann, wobei das Verfahren folgende Schritte umfasst:

- Erfassen einer Menge von Leiterplattentypen mit jeweils zugewiesenen doppelseitig bestückbaren Leiterplatten, die auf der Bestückungslinie innerhalb des Planungshorizonts bestückt werden sollen;
- Erfassen einer Menge von Bauelementtypen mit deren Platzverbrauch in Spuren in zumindest einer Bauelementezuführungseinrichtung;
- Erfassen einer Produktionszeit einer gleichzeitigen, als synchron bezeichneten Bestückung der ersten und zweiten Seite jeder zugewiesenen doppelseitig bestückbaren Leiterplatte auf der ersten und zweiten Transportspur;
- Erfassen einer Produktionszeit einer zeitlich versetzten, als asynchron bezeichneten Bestückung der ersten und zweiten Seite jeder zugewiesenen doppelseitig bestückbaren Leiterplatte auf der ersten und zweiten Transportspur;
- Erfassen einer Anzahl an Festrüstungs-Rüstfamilien, wobei jede Festrüstungs-Rüstfamilie eine Menge von Leiterplattentypen umfasst, deren Leiterplatten mit den Bauelementen der Bauelementtypen der Festrüstung auf der Bestückungslinie bestückbar ist;
- Zuordnen von Leiterplattentypen an jede Festrüstungs-Rüstfamilie, wobei alle Bauelemente zur Bestückung einer Leiterplatte eines Leiterplattentyps der zugeordneten Leiterplattentypen hinsichtlich ihres Platzverbrauchs in den in der Festrüstung verfügbaren Spuren Platz haben und in der Festrüstung gerüstet werden; und
- Optimieren der Zuordnung derart, dass der Produktionszeitgewinn, welcher aus den erfassten Produktionszeiten der synchronen und der asynchronen Bestückung über alle zugewiesenen doppelseitig bestückbaren Leiterplatten ermittelt wird, maximiert wird.

Aufgrund des Rüstens von Wechseltischen und damit zusätzlich benötigtem Equipment, ist eine Bestückungslinie in der Praxis dann effizient im Synchron-Modus betreibbar, wenn es dort nur Festrüstung (vorzugsweise nur eine) gibt und keine variablen Rüstungen aufgebaut werden müssen.

Eine Festrüst-Rüstfamilie umfasst eine Menge von Leiterplattentypen, deren Leiterplatten mit den Bauelementen der Bauelementtypen der Festrüstung auf der Bestückungslinie bestückbar ist.

Eine Weiterbildung der Erfindung sieht vor, dass pro Festrüstungs-Rüstfamilie die Leiterplatten der zugeordneten Leiterplattentypen dieselbe Leiterplattenbreite aufweisen, damit die Leiterplatten in die Transportspur hinsichtlich der Transportspurbreite passen.

Es sollten daher nur Leiterplatten einer Leiterplattenbreite verwendet werden, um Breitenverstellungen an der Bestückungslinie zu vermeiden. Zudem ist es besonders vorteilhaft, wenn die verwendeten Leiterplatten eine hohe Stückzahl aufweisen.

Die Summe der Produktionszeiten der Leiterplattentypen einer Festrüstungs-Rüstfamilie sollte eine vorgebbare obere Schranke unterschreiten und/oder eine vorgebbare untere Schranke überschreiten.

Das Optimieren wird vorzugsweise mittels Gemischt Ganzzahliger Programmierung durchgeführt.

Letztendlich können die Leiterplatten auf der Bestückungslinie mittels der mindestens einen Festrüstung bestückt werden. Vorzugsweise sollten auf der Bestückungslinie Leiterplatten mit nur einer Festrüstung bestückt werden.

Der wirtschaftliche Nutzen sowie Einsparungen an Equipment und Produktionszeit sind sehr hoch.

Ein weiterer Aspekt der Erfindung sieht eine Steuereinrichtung vor. Die Steuereinrichtung bzw. Steuerungsvorrichtung ist zur Bestimmung mindestens einer Festrüstung für eine Bestückungslinie ausgelegt, welche mit einem Leiterplattendoppeltransportsystem eingerichtet ist, dessen erste Transportspur doppelseitig bestückbare Leiterplatten eines Leiterplattentyps transportieren, deren erste Seite bestückt werden können, und dessen zweite Transportspur doppelseitig bestückbare Leiterplatten des (gleichen) Leiterplattentyps transportieren kann, deren zweite Seite bestückt werden können, wobei jede Festrüstung eine Anzahl an Bauelementtypen umfasst, die zur Bestückung der Leiterplatten einer dieser Festrüstung zugeordneten Festrüstungs-Rüstfamilie von Leiterplattentypen ausreicht, wobei die mindestens eine Festrüstung während des Planungshorizonts unverändert bleibt und mehrfach an der Bestückungslinie eingesetzt werden kann, wobei die Steuerungsvorrichtung dazu ausgelegt ist, folgende Schritte auszuführen:

- Erfassen einer Menge von Leiterplattentypen mit jeweils zugewiesenen doppelseitig bestückbaren Leiterplatten, die auf der Bestückungslinie innerhalb des Planungshorizonts bestückt werden sollen;
- Erfassen einer Menge von Bauelementtypen mit deren Platzverbrauch in Spuren in zumindest einer Bauelementezuführungseinrichtung;
- Erfassen einer Produktionszeit einer gleichzeitigen, als synchron bezeichneten Bestückung der ersten und zweiten Seite jeder zugewiesenen doppelseitig bestückbaren Leiterplatte auf der ersten und zweiten Transportspur;
- Erfassen einer Produktionszeit einer zeitlich versetzten, als asynchron bezeichneten Bestückung der ersten und zweiten Seite jeder zugewiesenen doppelseitig bestückbaren Leiterplatte auf der ersten und zweiten Transportspur;
- Erfassen einer Anzahl an Festrüstungs-Rüstfamilien, wobei jede Festrüstungs-Rüstfamilie eine Menge von Leiterplattentypen umfasst, deren Leiterplatten mit den Bauelementen der Bauelementtypen der Festrüstung auf der Bestückungslinie bestückbar ist;
- Zuordnen von Leiterplattentypen an jede Festrüstungs-Rüstfamilie, wobei alle Bauelemente zur Bestückung einer Leiterplatte eines Leiterplattentyps der zugeordneten Leiterplattentypen hinsichtlich ihres Platzverbrauchs in den in der Festrüstung verfügbaren Spuren Platz haben und in der Festrüstung gerüstet werden; und
- Optimieren der Zuordnung derart, dass der Produktionszeitgewinn, welcher aus den erfassten Produktionszeiten der synchronen und der asynchronen Bestückung über alle zugewiesenen doppelseitig bestückbaren Leiterplatten ermittelt wird, maximiert wird.

Die Einheiten bzw. die Einrichtung, die dazu eingerichtet sind, solche Verfahrensschritte auszuführen, können hardware-, firmware- und/oder softwaremäßig implementiert sein.

Ein weiterer Aspekt der Erfindung ist ein Computerprogramm(-produkt) mit Programmcodemitteln zur Durchführung des Verfahrens nach einem der vorangehenden Verfahrensansprüche, wenn es auf einer Steuerungsvorrichtung der oben genannten Art abläuft oder auf einem computerlesbaren Speichermedium gespeichert ist.

Das Computerprogramm bzw. -produkt kann auf einem computerlesbaren Speichermedium gespeichert sein. Das Computerprogramm bzw. -produkt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen. Diese Verarbeitungseinrichtung kann in der Steuereinrichtung oder in deren Mitteln integriert sein.

Die Steuerungsvorrichtung sowie das Computerprogramm(-produkt) können analog zum oben genannten Verfahren und dessen Weiterbildungen weiter- bzw. ausgebildet sein.

Weitere Vorteile, Einzelheiten und Weiterbildungen der Erfindung ergeben sich aus der nachfolgenden Beschreibung von Ausführungsbeispielen in Verbindung mit den Zeichnungen.

Die Figur zeigt ein Bearbeitungssystem zur Bearbeitung von Werkstücken.

Figur 1 zeigt ein Bestückungssystem 100. Das Bestückungssystem 100 umfasst eine oder mehrere Bestückungslinien 110 und eine Steuereinrichtung 115. Jede Bestückungslinie 110 umfasst ein Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Wechseltisch 140 Bauelemente 155 aufzunehmen und an einer vorbestimmten Position auf der Leiterplatte 120 zu positionieren, die sich auf dem Transportsystem 125 befindet. Das Transportsystem ist vorzugsweise als Leiterplattendoppeltransportsystem eingerichtet, dessen erste Transportspur 201 doppelseitig bestückbare Leiterplatten 120 eines Leiterplattentyps 122 transportiert, deren erste Seite bestückt werden, und dessen zweite Transportspur 202 doppelseitig bestückbare Leiterplatten 120 des Leiterplattentyps 122 transportiert, deren zweite Seite bestückt werden.

Während des Bestückungsvorgangs steht die Leiterplatte 120 bezüglich des Bestückungsautomaten 130 üblicherweise still. Die Wechseltische 140 umfassen jeweils eine Vielzahl Zuführungseinrichtungen 150, von denen in Figur 1 exemplarisch nur eine dargestellt ist. Jede Bauelementezuführungseinrichtung 150 hält einen Vorrat von Bauelementen 155 eines vorbestimmten Bauelementetyps 160 bereit. Für die Bauelemente 155 hat die Bauelementezuführungseinrichtung 150 ein Fassungsvermögen, das üblicherweise in Spuren ausgedrückt wird. Eine Spur ist üblicherweise 8 mm breit und die Zahl der Spuren jeder Bauelementezuführungseinrichtung 150 ist beschränkt, beispielsweise auf 40. Bauelemente 155 des gleichen Bauelementetyps 160 sind üblicherweise bereitgestellt in einem Gurt, auf einem Tablett oder in einer Röhre. Jeder Bauelementetyp 160 erfordert an der Bauelementezuführungseinrichtung 150 eine vorbestimmte Anzahl Spuren, die üblicherweise aneinander angrenzen müssen.

Jede Bauelementezuführungseinrichtung 150 kann zur Bereithaltung unterschiedlicher Bauelemente 155 konfiguriert werden und üblicherweise können unterschiedliche Bauelementezuführungseinrichtungen 150 an einem Wechseltisch 140 angebracht werden. Wird ein Bauelement 155 eines Bauelementtyps 160 am Bestückungsautomaten 130 benötigt, der nicht in einem der Wechseltische 140 vorhanden ist, so wird üblicherweise nicht einer der angebrachten Wechseltische 140 mit den benötigten Bauelementen 155 versehen, sondern komplett gegen einen anderen, entsprechend bestückten Wechseltisch 140 ausgetauscht. Das Aufrüsten eines einzuwechselnden Wechseltischs 140 mit Bauelementen 155 wird Vorrüstung genannt und kann eine Bearbeitungszeit im Stundenbereich erfordern.

Da ein Wechsel von Wechseltischen 140 an der Bestückungslinie 110 üblicherweise mit einem Produktionsstillstand verbunden ist, wird angestrebt, möglichst seltene Wechsel der Wechseltische 140 durchzuführen.

Zur Bestückung einer vorbestimmten Menge von Leiterplatten 120 können Rüstungen gebildet sein, die jeweils Vorräte von Bauelementen 155 von vorbestimmten Bauelementtypen 160 umfassen, wobei jede der Leiterplatten 120 der Menge mit Bauelementen 155 der Rüstung vollständig bestückt werden kann. Eine Rüstung kann realisiert sein durch eine Anzahl Wechseltische 140. In der Darstellung von Figur 1 sind eine Festrüstung 165, deren Wechseltische 140 an der Bestückungslinie 110 angebracht sind, und eine Variantenrüstung 170, deren Wechseltische 140 von der Fertigungslinie 110 getrennt sind, gebildet. Es können eine oder mehrere Festrüstungen vorgesehen sein. Ein angestrebter Fall ist ohne Variantenrüstungen 170 auszukommen, insbesondere, wenn ein Leiterplattendoppeltransportsystem im Synchron-Betrieb zum Einsatz kommt.

Die Festrüstung 165 ist dazu eingerichtet, zumindest während eines Planungshorizonts, der beispielsweise ein halbes Jahr oder ein Jahr betragen kann, bezüglich seiner Bauelementtypen 160 unverändert zu bleiben. Es können also im Bedarfsfall zwar Bauelemente 155 an den Wechseltischen 140 der Festrüstung 165 nachgefüllt werden, die Zuordnung von Bauelementtypen 160 zu Spuren der Wechseltische 140 bleibt jedoch unverändert. Sind mehrere Festrüstungen 165 vorgesehen, so können diese innerhalb des Planungshorizonts gegeneinander oder gegen eine der Variantenrüstungen 170 ausgetauscht werden.

Eine Variantenrüstung 170 hingegen ist dazu eingerichtet, während des Planungshorizonts Bauelemente 155 unterschiedlicher Bauelementtypen 160 aufzunehmen, besteht aber nur temporär. Dazu werden üblicherweise die Wechseltische 170, während sie nicht an der Bestückungslinie 110 angebracht sind, von Bauelementen 155 vorbestimmter Bauelementtypen 160 abgerüstet und mit Bauelementen 155 anderer Bauelementtypen 160 aufgerüstet. Diese Umrüstung kann einen erheblichen Anteil manueller Arbeit umfassen und zeitaufwändig sein.

Die Steuereinrichtung 115 ordnet Leiterplattentypen 122, deren zugeordnete Leiterplatten 120 auf der Bestückungslinie 110 bestückt werden sollen, einer Rüstfamilie zu. Eine Rüstfamilie ist eine Menge von Leiterplattentypen 122, deren Leiterplatten 120 vollständig mit Bauelementen 155 bestückt werden können, die in der zugeordneten Rüstung 165, 170 bereitgestellt sind. Eine Rüstfamilie ist üblicherweise genau einer Rüstung 165, 170 zugeordnet und umgekehrt.

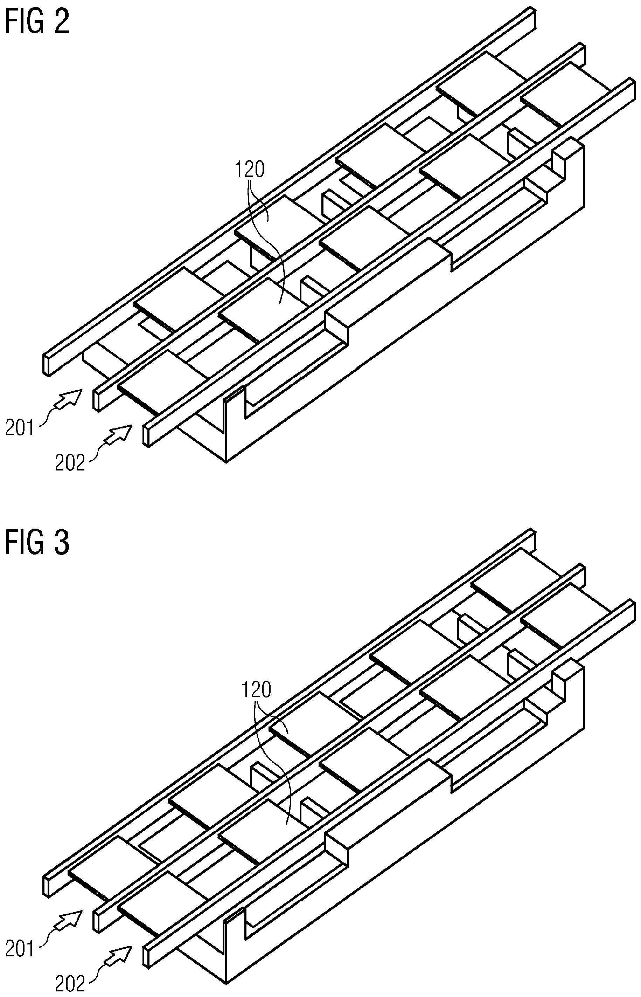

Figuren 2 und zeigen jeweils einen Ausschnitt eines Leiterplattendoppeltransportsystems mit zwei Transportspuren 201 und 202, das durch einem Bestückungsautomaten 130 durchführt. In Figur 2 wird der eingangs erläuterte Asynchron-Betrieb gezeigt. In Figur 3 wird der eingangs erklärte Synchron-Betrieb gezeigt.

Mit der folgenden Optimierungsmethode kann das Zuordnen von Leiterplattentypen an eine oder mehrere Festrüstungs-Rüstfamilien, wobei alle Bauelemente zur Bestückung einer Leiterplatte eines Leiterplattentyps der zugeordneten Leiterplattentypen hinsichtlich ihres Platzverbrauchs in den in der Festrüstung verfügbaren Spuren Platz haben und in der Festrüstung gerüstet werden, durchgeführt werden.

Ein Spezialfall von Optimierungsmethoden ist die lineare Optimierung. Sie befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung. Ein sogenannter Solver (Löser) ist eine Sammelbezeichnung für spezielle mathematische Computerprogramme, die mathematische Probleme numerisch lösen können. Im Zusammenhang mit MILP (mixed integer linear programming bzw. gemischt ganzzahlige lineare Programmierung) können für IP-Programme (ganzzahlige Optimierungsmodelle) Standardsolver wie z.B. CPLEX, Scip, Gurobi, Xpress verwendet werden.

Typischerweise wird eine Startkonfiguration vorgegeben, die iterativ mittels Optimierung zu einem Zielergebnis geführt wird. Ziel ist es im Beispiel, dass der Produktionszeitgewinn, welcher aus den erfassten Produktionszeiten der synchronen und der asynchronen Bestückung über alle zugewiesenen doppelseitig bestückbaren Leiterplatten ermittelt wird, maximiert wird.

Im Folgenden wird ein MILP-Modell zur Bestimmung von Festrüstungs-Rüstfamilien für eine gegebene, im Synchron-Modus zu betreibende Bestückungslinie vorgeschlagen. Der Ansatz basiert auf gemischt ganzzahliger linearer Optimierung.

Es werden die Rüstfamilien für den Synchron-Betrieb der Linie so gebildet, dass der Produktionszeitgewinn gegenüber einer Fertigung der Baugruppen im Asynchron-Modus maximiert wird. Dabei sind verschiedene Restriktionen einzuhalten:

- Einhaltung einer Mindest-Produktionszeit, diw gewährleistet, dass die Linie nicht unterlastet ist.

- Einhaltung einer maximalen Produktionszeit, die gewährleistet, dass die Linie nicht überlastet ist.

- In einer Rüstfamilie dürfen sich keine unterschiedlichen Leiterplattenbreiten befinden.

- Die Bauelement-Rüstung einer Rüstfamilie muss an der Linie rüstbar sein.

In der MILP-Formulierung gelten die folgenden Bezeichnungen.

Indices

| | |
|---|---|
| $C$ | Menge der Bauelementtypen |
| $R$ | Menge der Baugruppen (Synchron-Boards mit Ober- und Unterseite) |
| $R_C$ | Menge der Baugruppen mit Bauelementtyp $c$ |
| $Cl$ | Menge der Festrüstungen/ Festrüstungsfamilien $Cl$ |

**Parameter**

| | |
|---|---|
| $Width_c$ | Platzverbrauch eines Bauelementtyps $c$ in Spuren |
| $LineCap$ | Anzahl der Spuren der Bauelementtypen, die in der Rüstung einer Rüstfamilie Platz haben |
| $UpperTimeLimit$ | Obere Produktionszeitschranke aller der Bestückungslinie zugewiesenen |
| Baugruppen $LowerTimeLimit$ | Untere Produktionszeitschranke aller der Bestückungslinie zugewiesenen Baugruppen |
| $TimeSync_r$ | Gesamte Produktionszeit der Baugruppe $r$, falls sie im Synchron-Modus gefertigt wird |
| $TimeASync_r$ | Gesamte Produktionszeit der Ober- und Unterseiten der Baugruppe $r$, falls diese im Asynchron-Modus gefertigt werden |
| $BoardWidth_r$ | Leiterplattenbreite der Baugruppe r |

**Binärvariablen**

| | |
|---|---|
| $assign_{r,cl}$ | Variable, die angibt, ob eine Baugruppe r der Rüstfamilie cl zugeordnet wird. (In diesem Fall nimmt sie den Wert 1 an, anderenfalls den Wert 0) |
| $setup_{c, cl}$ | Variable, die angibt ob der Bauelementtyp c in der Rüstung der Rüstfamilie cl gerüstet werden muss. (In diesem Fall nimmt sie den Wert 1 an, anderenfalls den Wert 0) |

Zielfunktion:

$$Maximiere \sum_{cl \in Cl} \sum_{r \in R} assign_{r,cl} \, (TimeAsync_r - TimeSync_r)$$

Nebenbedingungen:

(1) Jeder Baugruppentyp darf höchstens einer Rüstfamilie zugeordnet sein.

$$\sum_{cl \in Cl} assign_{r,cl} \leq 1 \qquad r \in R$$

(2) Die Bauelementtypen der Baugruppen einer Rüstfamilie müssen in eine Rüstung passen.

$$\sum_{c \in C} Width_c \, setup_{c,cl} \leq LineCap \qquad cl \in Cl$$

(3) Alle Bauelementtypen einer Rüstfamilie müssen in der Rüstung der Rüstfamilie gerüstet werden

$$\sum_{r \in R_c} assign_{r,cl} \leq |R_c| setup_{c,cl} \qquad c \in C, cl \in Cl$$

(4) Die Summe der Produktionszeiten der Baugruppentypen einer Rüstfamilie darf die obere Produktionszeitschranke nicht überschreiten.

$$\sum_{cl \in Cl} \sum_{r \in R} assign_{r,cl} Time_r \leq UpperTimeLimit$$

(5) Die Summe der Produktionszeiten der Baugruppentypen einer Rüstfamilie darf die untere Produktionszeitschranke nicht unterschreiten.

$$\sum_{cl \in Cl} \sum_{r \in R} assign_{r,cl} Time_r \geq LowerTimeLimit$$

(6) Alle einer Rüstfamilie zugewiesenen Baugruppen müssen dieselbe Leiterplattenbreite besitzen

$$assign_{r,cl} + assign_{r',cl} \leq 1 \qquad cl \in Cl, r, r' \in R, BoardWidth_r \neq BoardWidth_{r'}$$

(7) Variablenrestriktionen

$$assign_{r,cl} \in \{0,1\} \qquad r \in R, cl \in Cl$$

$$setup_{c,cl} \in \{0,1\} \qquad c \in C, cl \in Cl$$

Im Beispiel konnten in einem Leiterplattenproduktionswerk durch die mit dem erfinderischen Verfahren erzielten Produktionszeitreduktionen zwei von 15 Bestückungslinien eingespart werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Die Implementierung der vorstehend beschriebenen Prozesse oder Verfahrensabläufe kann anhand von Instruktionen erfolgen, die auf computerlesbaren Speichermedien oder in flüchtigen Computerspeichern (im Folgenden zusammenfassend als computerlesbare Speicher bezeichnet) vorliegen. Computerlesbare Speicher sind beispielsweise flüchtige Speicher wie Caches, Puffer oder RAM sowie nichtflüchtige Speicher wie Wechseldatenträger, Festplatten, usw.

Die vorstehend beschriebenen Funktionen oder Schritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen Speichern abgelegt sein, es ist aber auch möglich, die Instruktionen auf einem entfernten System abzulegen und darauf via Netzwerk zuzugreifen.

Unter "rechnergestützt" kann im Zusammenhang mit der Erfindung beispielsweise eine Implementierung des Verfahrens verstanden werden, bei dem insbesondere ein Prozessor, der Teil der Steuerungsvorrichtung bzw. -einheit sein kann, mindestens einen Verfahrensschritt des Verfahrens ausführt.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Vorrichtungen bzw. Einrichtungen bzw. Einheiten bestehen. Besteht ein Prozessor aus mehreren Vorrichtungen, können diese zur parallelen oder sequentiellen Verarbeitung bzw. Ausführung von Instruktionen ausgelegt bzw. konfiguriert sein. Unter einer "Speichereinheit" kann im Zusammenhang mit der Erfindung beispielsweise ein Speicher in Form von Arbeitsspeicher (engl. Random-Access Memory, RAM) oder eine Festplatte verstanden werden.

## Patentansprüche

1. Verfahren zur Bestimmung mindestens einer Festrüstung (165) für eine Bestückungslinie (110), welche mit einem Leiterplattendoppeltransportsystem (125) eingerichtet ist, dessen erste Transportspur (201) doppelseitig bestückbare Leiterplatten (120) eines Leiterplattentyps (122) transportiert, deren erste Seite bestückt werden, und dessen zweite Transportspur (202) doppelseitig bestückbare Leiterplatten des Leiterplattentyps transportiert, deren zweite Seite bestückt werden, wobei jede Festrüstung eine Anzahl an Bauelementtypen (160) umfasst, die zur Bestückung der Leiterplatten einer dieser Festrüstung zugeordneten Festrüstungs-Rüstfamilie von Leiterplattentypen ausreicht, wobei die mindestens eine Festrüstung während eines Planungshorizonts unverändert bleibt und mehrfach an der Bestückungslinie eingesetzt werden kann, wobei das Verfahren folgende Schritte umfasst:

   - Erfassen einer Menge von Leiterplattentypen mit jeweils zugewiesenen doppelseitig bestückbaren Leiterplatten, die auf der Bestückungslinie innerhalb des Planungshorizonts bestückt werden sollen;
   - Erfassen einer Menge von Bauelementtypen mit deren Platzverbrauch in Spuren in zumindest einer Bauelementezuführungseinrichtung (150);
   - Erfassen einer Produktionszeit einer gleichzeitigen, als synchron bezeichneten Bestückung der ersten und zweiten Seite jeder zugewiesenen doppelseitig bestückbaren Leiterplatte auf der ersten und zweiten Transportspur;
   - Erfassen einer Produktionszeit einer zeitlich versetzten, als asynchron bezeichneten Bestückung der ersten und zweiten Seite jeder zugewiesenen doppelseitig bestückbaren Leiterplatte auf der ersten und zweiten Transportspur;
   - Erfassen einer Anzahl an Festrüstungs-Rüstfamilien, wobei jede Festrüstungs-Rüstfamilie eine Menge von Leiterplattentypen umfasst, deren Leiterplatten mit den Bauelementen der Bauelementtypen der Festrüstung auf der Bestückungslinie bestückbar ist;
   - Zuordnen von Leiterplattentypen an jede Festrüstungs-Rüstfamilie, wobei alle Bauelemente zur Bestückung einer Leiterplatte eines Leiterplattentyps der zugeordneten Leiterplattentypen hinsichtlich ihres Platzverbrauchs in den in der Festrüstung verfügbaren Spuren Platz haben und in der Festrüstung gerüstet werden; und
   - Optimieren der Zuordnung derart, dass ein Produktionszeitgewinn, welcher aus den erfassten Produktionszeiten der synchronen und der asynchronen Bestückung über alle zugewiesenen doppelseitig bestückbaren Leiterplatten ermittelt wird, maximiert wird.

**2.** Verfahren nach dem vorhergehenden Anspruch, **dadurch gekennzeichnet, dass** pro Festrüstungs-Rüstfamilie die Leiterplatten der zugeordneten Leiterplattentypen dieselbe Leiterplattenbreite aufweisen, damit die Leiterplatten in die Transportspur hinsichtlich der Transportspurbreite passen.

**3.** Verfahren nach einem der vorhergehenden Ansprüche, **dadurch gekennzeichnet, dass** auf der Bestückungslinie Leiterplatten mit nur einer Festrüstung bestückt werden.

**4.** Verfahren nach einem der vorhergehenden Ansprüche, **dadurch gekennzeichnet, dass** eine Summe der Produktionszeiten der Leiterplattentypen einer Festrüstungs-Rüstfamilie eine vorgebbare obere Schranke unterschreitet.

**5.** Verfahren nach einem der vorhergehenden Ansprüche, **dadurch gekennzeichnet, dass** die Summe der Produktionszeiten der Leiterplattentypen einer Festrüstungs-Rüstfamilie eine vorgebbare untere Schranke überschreitet.

**6.** Verfahren nach einem der vorhergehenden Ansprüche, **dadurch gekennzeichnet**, das Optimieren mittels Gemischt Ganzzahliger Programmierung durchgeführt wird.

**7.** Steuereinrichtung (115) zur Bestimmung mindestens einer Festrüstung (165) für eine Bestückungslinie (110), welche mit einem Leiterplattendoppeltransportsystem (125) eingerichtet ist, dessen erste Transportspur (201) derart ausgestaltet ist, doppelseitig bestückbare Leiterplatten (120) eines Leiterplattentyps (122) zu transportieren, deren erste Seite bestückt werden können, und dessen zweite Transportspur (202) derart ausgestaltet ist, doppelseitig bestückbare Leiterplatten des Leiterplattentyps zu transportieren, deren zweite Seite bestückt werden können, wobei jede Festrüstung eine Anzahl an Bauelementtypen (160) umfasst, die zur Bestückung der Leiterplatten einer dieser Festrüstung zugeordneten Festrüstungs-Rüstfamilie von Leiterplattentypen ausreicht, wobei die mindestens eine Festrüstung während eines Planungshorizonts unverändert bleibt und mehrfach an der Bestückungslinie eingesetzt werden kann, wobei die Steuerungsvorrichtung dazu ausgelegt ist, folgende Schritte auszuführen:

- Erfassen einer Menge von Leiterplattentypen mit jeweils zugewiesenen doppelseitig bestückbaren Leiterplatten, die auf der Bestückungslinie innerhalb des Planungshorizonts bestückt werden sollen;
- Erfassen einer Menge von Bauelementtypen mit deren Platzverbrauch in Spuren in zumindest einer Bauelementezuführungseinrichtung (150);
- Erfassen einer Produktionszeit einer gleichzeitigen, als synchron bezeichneten Bestückung der ersten und zweiten Seite jeder zugewiesenen doppelseitig bestückbaren Leiterplatte auf der ersten und zweiten Transportspur;
- Erfassen einer Produktionszeit einer zeitlich versetzten, als asynchron bezeichneten Bestückung der ersten und zweiten Seite jeder zugewiesenen doppelseitig bestückbaren Leiterplatte auf der ersten und zweiten Transportspur;
- Erfassen einer Anzahl an Festrüstungs-Rüstfamilien, wobei jede Festrüstungs-Rüstfamilie eine Menge von Leiterplattentypen umfasst, deren Leiterplatten mit den Bauelementen der Bauelementtypen der Festrüstung auf der Bestückungslinie bestückbar ist;
- Zuordnen von Leiterplattentypen an jede Festrüstungs-Rüstfamilie, wobei alle Bauelemente zur Bestückung einer Leiterplatte eines Leiterplattentyps der zugeordneten Leiterplattentypen hinsichtlich ihres Platzverbrauchs in den in der Festrüstung verfügbaren Spuren Platz haben und in der Festrüstung gerüstet werden; und
- Optimieren der Zuordnung derart, dass ein Produktionszeitgewinn, welcher aus den erfassten Produktionszeiten der synchronen und der asynchronen Bestückung über alle zugewiesenen doppelseitig bestückbaren Leiterplatten ermittelt wird, maximiert wird.

**8.** Steuerungsvorrichtung nach dem vorhergehenden Anspruch, **dadurch gekennzeichnet, dass** pro Festrüstungs-Rüstfamilie die Leiterplatten der zugeordneten Leiterplattentypen dieselbe Leiterplattenbreite aufweisen, damit die Leiterplatten in die Transportspur hinsichtlich der Transportspurbreite passen.

**9.** Computerprogrammprodukt mit Programmcodemitteln zur Durchführung des Verfahrens nach einem der vorhergehenden Verfahrensansprüche, wenn es durch einen Prozessor insbesondere der Steuerungsvorrichtung nach dem vorhergehenden Anspruch ausgeführt wird.

**Claims**

**1.** Method for determining at least one fixed setup (165) for an assembly line (110) which is configured with a printed circuit board double transport system (125) of which the first transport track (201) transports double-sided printed circuit boards (120) of a printed circuit board type (122) of which the first side is populated, and of which the second transport track (202) transports double-sided printed circuit boards of the printed circuit board type of which the second side is populated, wherein each fixed setup comprises a number of component types (160) that is sufficient to populate the printed circuit boards of a fixed-setup setup family, which is associated with this fixed setup, of printed circuit board types, wherein the at least one fixed setup remains unchanged during a planning horizon and can be used several times on the assembly line, wherein the method comprises the following steps:

- detecting a set of printed circuit board types each with allocated double-sided printed circuit boards which are intended to be populated on the assembly line within the planning horizon;
- detecting a set of component types together with their space requirement in tracks in at least one component feed device (150) ;
- detecting a production time for simultaneous, referred to as synchronous, population of the first and second side of each allocated double-sided printed circuit board on the first and second transport track;
- detecting a production time for staggered, referred to as asynchronous, population of the first and second side of each allocated double-sided printed circuit board on the first and second transport track;
- detecting a number of fixed-setup setup families, wherein each fixed-setup setup family comprises a set of printed circuit board types of which the printed circuit boards can be populated with the components of the component types of the fixed setup on the assembly line;
- assigning printed circuit board types to each fixed-setup setup family, wherein all the components for populating a printed circuit board of a printed circuit board type of the assigned printed circuit board types have the space they require in the tracks available in the fixed setup and are set up in the fixed setup; and
- optimizing the assignment process in such a way that a production time saving, which is identified from the detected production times of the synchronous and asynchronous population over all the allocated double-sided printed circuit boards, is maximized.

2. Method according to the preceding claim, **characterized in that**, for each fixed-setup setup family, the printed circuit boards of the assigned printed circuit board types have the same printed circuit board width, so that the printed circuit boards fit into the transport track with respect to the transport track width.

3. Method according to either of the preceding claims, **characterized in that** printed circuit boards with only one fixed setup are populated on the assembly line.

4. Method according to one of the preceding claims, **characterized in that** a sum of production times of the printed circuit board types of a fixed-setup setup family falls below a pre-specifiable upper limit.

5. Method according to one of the preceding claims, **characterized in that** the sum of production times for the printed circuit board types of a fixed-setup setup family exceeds a pre-specifiable lower limit.

6. Method according to one of the preceding claims, **characterized in that** optimization is carried out by means of mixed integer programming.

7. Control device (115) for determining at least one fixed setup (165) for an assembly line (110) which is configured with a printed circuit board double transport system (125) of which the first transport track (201) is configured so as to transport double-sided printed circuit boards (120) of a printed circuit board type (122) of which the first side can be populated, and of which the second transport track (202) is configured so as to transport double-sided printed circuit boards of the printed circuit board type of which the second side can be populated, wherein each fixed setup comprises a number of component types (160) that is sufficient to populate the printed circuit boards of a fixed-setup setup family, which is associated with this fixed setup, of printed circuit board types, wherein the at least one fixed setup remains unchanged during a planning horizon and can be used several times on the assembly line, wherein the control device is designed to execute the following steps:

- detecting a set of printed circuit board types each with allocated double-sided printed circuit boards which are intended to be populated on the assembly line within the planning horizon;
- detecting a set of component types together with their space requirement in tracks in at least one component feed device (150) ;
- detecting a production time for simultaneous, referred to as synchronous, population of the first and second side of each allocated double-sided printed circuit board on the first and second transport track;

- detecting a production time for staggered, referred to as asynchronous, population of the first and second side of each allocated double-sided printed circuit board on the first and second transport track;
- detecting a number of fixed-setup setup families, wherein each fixed-setup setup family comprises a set of printed circuit board types of which the printed circuit boards can be populated with the components of the component types of the fixed setup on the assembly line;
- assigning printed circuit board types to each fixed-setup setup family, wherein all the components for populating a printed circuit board of a printed circuit board type of the assigned printed circuit board types have the space they require in the tracks available in the fixed setup and are set up in the fixed setup; and
- optimizing the assignment process in such a way that a production time saving, which is identified from the detected production times of the synchronous and asynchronous population over all the allocated double-sided printed circuit boards, is maximized.

8. Control device according to the preceding claim, **characterized in that**, for each fixed-setup setup family, the printed circuit boards of the assigned printed circuit board types have the same printed circuit board width, so that the printed circuit boards fit into the transport track with respect to the transport track width.

9. Computer program product with program code means for carrying out the method according to one of the preceding method claims when it is executed by a processor, in particular of the control device according to the preceding claim.

**Revendications**

1. Procédé de détermination d'au moins une installation fixe (165) pour une ligne de montage (110), laquelle est configurée avec un système de transport double de cartes de circuits imprimés (125), dont la première piste de transport (201) transporte des cartes de circuits imprimés double face (120) d'un type de carte de circuits imprimés (122) dont la première face est montée, et dont la deuxième piste de transport (202) transporte des cartes de circuits imprimés double face du type de carte de circuits imprimés, dont la deuxième face est montée, dans lequel chaque installation fixe comprend un certain nombre de types de composants (160), qui suffit pour le montage des cartes de circuits imprimés d'une famille d'équipement d'installation fixe affectée à cette installation fixe de types de cartes de circuits imprimés, dans lequel la au moins une installation fixe demeure inchangée pendant un horizon de planification et peut être utilisée plusieurs fois sur la ligne de montage, dans lequel le procédé comprend les étapes suivantes :

   - saisie d'une quantité de types de cartes de circuits imprimés avec des cartes de circuits imprimés double face attribuées à chaque fois, qui doivent être montées sur la ligne de montage au sein de l'horizon de planification ;
   - saisie d'une quantité de types de composants avec leur exigence d'espace dans des pistes dans au moins un dispositif d'alimentation en composants (150) ;
   - saisie d'un temps de production d'un montage simultané, désigné comme synchrone de la première et la deuxième face de chaque carte de circuits imprimés double face attribuée sur la première et la deuxième piste de transport ;
   - saisie d'un temps de production d'un montage décalé dans le temps, désigné comme asynchrone de la première et la deuxième face de chaque carte de circuits imprimés double face attribuée sur la première et la deuxième piste de transport ;
   - saisie d'un certain nombre de familles d'équipement d'installation fixe, dans lequel chaque famille d'équipement d'installation fixe comprend une quantité de types de cartes de circuits imprimés, ces cartes de circuits imprimés peuvent être montées sur la ligne de montage avec les composants des types de composants de l'installation fixe ;
   - affectation des types de cartes de circuits imprimés à chaque famille d'équipement d'installation fixe, dans lequel tous les composants pour le montage d'une carte de circuits imprimés d'un type de carte de circuits imprimés des types de cartes de circuits imprimés affectés, concernant leur exigence d'espace, ont de la place dans les pistes disponibles dans l'installation fixe et sont disposés dans l'installation fixe ; et
   - optimisation de l'affectation de sorte qu'un gain de temps de production, lequel est déterminé à partir des temps de production saisis du montage synchrone et du montage asynchrone sur toutes les cartes de circuits imprimés double face attribuées, est maximisé.

2. Procédé selon la revendication précédente, **caractérisé en ce que** par famille d'équipement d'installation fixe, les cartes de circuits imprimés des types de cartes de circuits imprimés affectés présentent la même largeur de cartes de circuits imprimés, ainsi les cartes de circuits imprimés correspondent à la piste de transport en ce qui concerne la largeur de piste de transport.

**3.** Procédé selon l'une des revendications précédentes, **caractérisé en ce que** sur la ligne de montage, des cartes de circuits imprimés sont montées avec uniquement une installation fixe.

**4.** Procédé selon l'une des revendications précédentes, **caractérisé en ce qu'**une somme des temps de production des types de cartes de circuits imprimés d'une famille d'équipement d'installation fixe est inférieure à une limite supérieure pouvant être prédéfinie.

**5.** Procédé selon l'une des revendications précédentes, **caractérisé en ce que** la somme des temps de production des types de cartes de circuits imprimés d'une famille d'équipement d'installation fixe dépasse une limite inférieure pouvant être prédéfinie.

**6.** Procédé selon l'une des revendications précédentes, **caractérisé en ce que** l'optimisation est réalisée au moyen de la programmation en nombres entiers mixtes.

**7.** Dispositif de commande (115) de détermination d'au moins une installation fixe (165) pour une ligne de montage (110), laquelle est configurée avec un système de transport double de cartes de circuits imprimés(125) dont la première piste de transport (201) est configurée d'une manière à transporter des cartes de circuits imprimés double face (120) d'un type de carte de circuits imprimés (122), dont la première face peut être montée, et dont la deuxième piste de transport (202) est configurée d'une manière à transporter des cartes de circuits imprimés double face du type de carte de circuits imprimés, dont la deuxième face peut être montée, dans lequel chaque installation fixe comprend un certain nombre de types de composants (160) qui suffit pour le montage des cartes de circuits imprimés d'une famille d'équipement d'installation fixe, affectée à cette installation fixe, de types de cartes de circuits imprimés, dans lequel la au moins une installation fixe demeure inchangée pendant un horizon de planification et peut être utilisée plusieurs fois sur la ligne de montage, dans lequel le dispositif de commande est conçu pour réaliser les étapes suivantes :

- saisie d'une quantité de types de cartes de circuits imprimés avec des cartes de circuits imprimés double face attribuées à chaque fois, qui doivent être montées sur la ligne de montage au sein de l'horizon de planification ;
- saisie d'une quantité de types de composants avec leur exigence d'espace dans des pistes dans au moins un dispositif d'alimentation en composants (150) ;
- saisie d'un temps de production d'un montage simultané, désigné comme synchrone de la première et la deuxième face de chaque carte de circuits imprimés double face attribuée sur la première et la deuxième piste de transport ;
- saisie d'un temps de production d'un montage décalé dans le temps, désigné comme asynchrone de la première et la deuxième face de chaque carte de circuits imprimés double face attribuée sur la première et la deuxième piste de transport ;
- saisie d'un certain nombre de familles d'équipement d'installation fixe, dans lequel chaque famille d'équipement d'installation fixe comprend une quantité de types de cartes de circuits imprimés, ces cartes de circuits imprimés peuvent être montées sur la ligne de montage avec les composants des types de composants de l'installation fixe ;
- affectation des types de cartes de circuits imprimés à chaque famille d'équipement d'installation fixe, dans lequel tous les composants pour le montage d'une carte de circuits imprimés d'un type de carte de circuits imprimés des types de cartes de circuits imprimés affectés, concernant leur exigence d'espace, ont de la place dans les pistes disponibles dans l'installation fixe et sont disposés dans l'installation fixe ; et
- optimisation de l'affectation de sorte qu'un gain de temps de production, lequel est déterminé à partir des temps de production saisis du montage synchrone et du montage asynchrone sur toutes les cartes de circuits imprimés double face attribuées, est maximisé.

**8.** Dispositif de commande selon la revendication précédente, **caractérisé en ce que** par famille d'équipement d'installation fixe, les cartes de circuits imprimés des types de cartes de circuits imprimés affectés présentent la même largeur de cartes de circuits imprimés, ainsi les cartes de circuits imprimés correspondent à la piste de transport en ce qui concerne la largeur de piste de transport.

**9.** Produit de programme informatique comprenant des moyens de codage de programme pour exécuter le procédé selon l'une des revendications précédentes, lorsqu'il est réalisé par un processeur, plus particulièrement le dispositif de commande selon la revendication précédente.

FIG 1

## FIG 2

120

201

202

## FIG 3

120

201

202

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20100325860 A1